# DEMANDE DE BREVET EUROPEEN

(11) **EP 0 843 364 A1**
(43) Date de publication de la demande: **20.05.1998**
(21) Numéro de dépôt: 97402749.2
(22) Date de dépôt: 17.11.1997
(51) Int. Cl.: H01L 31/0232

(54) **Détecteur multispectral à cavité résonante**

(30) Priorité: 19.11.1996 FR 9614093
(71) Demandeur: COMMISSARIAT A L'ENERGIE ATOMIQUE, 75015 Paris (FR)
(72) Inventeur: Pautrat, Jean-Louis, 38100 Grenoble (FR); Magnea, Noel, 38430 Moirans (FR); Hadji, Emmanuel, 38100 Grenoble (FR)
(74) Mandataire: Dubois-Chabert, Guy

(57) **Abrégé**

Il comprend au moins une cavité (2) résonant à au moins deux longueurs d'onde et contenant au moins deux couches (12, 14) qui absorbent les rayonnements correspondants et sont placées sur des ventres propres aux ondes stationnaires de la cavité et au moins deux jonctions P-N dont les zones de charge d'espace contiennent les couches. Pour chaque cavité sont prévus au moins deux contacts électriques pour polariser en inverse l'une ou l'autre des deux jonctions pour détecter le rayonnement correspondant.

Application en imagerie thermique.

## Description

### Domaine technique

La présente invention concerne un détecteur multispectral à cavité résonante.

Il s'agit d'un détecteur de rayonnements à base de semiconducteurs, qui est sensible dans au moins deux bandes spectrales.

L'invention s'applique plus particulièrement aux cas où les deux bandes spectrales sont dans le domaine infrarouge.

Elle a de nombreuses applications, notamment dans le domaine de l'identification d'objets et le domaine de l'imagerie thermique.

### Etat de la technique antérieure

Pour détecter un rayonnement infrarouge dans le domaine allant de 1 à 10 µm, on utilise couramment des matériaux semiconducteurs II-VI avec une bande interdite adaptée au rayonnement à absorber.

Différentes solutions ont été proposées jusqu'à présent pour absorber plusieurs longueurs d'onde au sein d'un même dispositif.

Une première solution consiste à disposer côte à côte des matériaux sensibles chacun à une longueur d'onde.

A ce sujet, on consultera le document (1) qui, comme les autres documents cités par la suite, est mentionné à la fin de la présente description.

Cette solution connue permet la réalisation de matrices de détecteurs mais, dans ce cas, chaque pixel se trouve partagé en plusieurs zones (une pour chaque longueur d'onde).

Chacune de ces zones ne peut donc absorber que la fraction du rayonnement incident tombant sur sa surface, ce qui limite l'efficacité du détecteur.

Une deuxième solution consiste à disposer l'un sur l'autre des matériaux sensibles chacun à une longueur d'onde.

Différentes structures sont possibles.

La solution la plus intéressante, permettant de détecter deux longueurs différentes, est d'avoir une structure NPN pour laquelle chaque zone de type N contient une couche active sensible à une longueur d'onde.

A ce sujet, on consultera le document (2).

La détection des deux longueurs d'onde dans un tel composant peut être simultanée ou séquentielle suivant que l'on dispose d'un ou de deux contacts par pixel en plus du contact commun à l'ensemble du réseau.

A ce sujet, on consultera le document (3).

Malheureusement, pour absorber une fraction suffisante des photons infrarouges, l'épaisseur d'un tel composant doit être élevée.

Ces dispositifs connus, dont l'épaisseur active est importante, sont lents et ne peuvent fonctionner qu'à basse température du fait du bruit engendré thermiquement dans le volume actif lorsque la température tend à s'approcher de la température ambiante.

De plus, la sélectivité en longueur d'onde est limitée par la largeur de la bande d'absorption des couches actives.

On sait aussi que la possibilité de renforcer l'absorption d'une couche active en la plaçant au sein d'une microcavité a été démontrée dans le domaine proche infrarouge.

Les auteurs de la présente invention l'ont vérifié de manière expérimentale dans la bande de longueurs d'onde allant de 3 à 5 µm.

En outre, des détecteurs à microcavités sensibles à deux longueurs d'onde ont récemment été proposés.

A ce sujet, on consultera le document (4).

La structure de ces détecteurs connus consiste en une couche active unique située à l'intérieur d'une microcavité capable de résonner à deux longueurs d'onde.

Ces détecteurs connus présentent deux inconvénients.

D'une part, les deux longueurs d'onde détectées ne peuvent être séparées électriquement du fait qu'elles sont absorbées dans une couche active unique.

D'autre part, l'efficacité quantique de tels détecteurs n'est pas la même pour les deux longueurs d'onde puisque le coefficient d'absorption de la couche active varie avec la longueur d'onde.

On connaît aussi par le document (5) un photodétecteur comprenant deux détecteurs placés à des distances fixes par rapport à un miroir permettant de créer un motif d'onde stationnaire à partir d'une lumière incidente. Ce photodétecteur pourrait en principe détecter un couple de longueurs d'onde pour lesquelles les milieux absorbeurs des détecteurs seraient disposés sur les ventres de l'onde stationnaire. Cependant si des lumières ayant d'autres longueurs d'onde se propageaient simultanément dans le photodétecteur ces lumières seraient absorbées de façon plus ou moins intense sur les deux détecteurs et également de façon imprévisible si les longueurs d'onde et les intensité de ces lumières ne sont pas connues. Ceci aboutirait à brouiller la réponse du photodétecteur qui ne pourrait donc pas fonctionner. Ce photodétecteur connu n'est pas sélectif pour deux longueurs d'onde.

On connaît en outre par le document (6) un photodétecteur comprenant une photodiode qui est prévue pour absorber un rayonnement ayant une longueur d'onde déterminée et qui est placée dans une cavité résonante. Il est également prévu de juxtaposer plusieurs photodétecteurs accordés sur différentes longueurs d'onde pour détecter ces longueurs d'onde.

Cependant on réduit ainsi d'un facteur n la puissance lumineuse qui atteint chaque photodétecteur où n est le nombre de photodétecteurs. De plus cette juxtaposition ne garantit pas que les n photodétecteurs voient la même source lumineuse.

### Exposé de l'invention

La présente invention a pour but de remédier aux inconvénients précédents.

Elle a pour objet un détecteur multispectral qui comprend au moins une cavité résonante en couches minces et dans lequel les couleurs sont séparées électriquement à chaque cavité résonante.

Chaque cavité résonante est conçue pour résonner à deux ou à plus de deux longueurs d'onde.

Dans chaque cavité, on utilise le fait que des ondes stationnaires propres aux différentes longueurs d'onde résonantes s'établissent pour séparer ces longueurs d'onde.

Dans ce but, on dispose des couches absorbantes sur des ventres propres à ces ondes stationnaires.

Des jonctions P-N, qui contiennent les couches absorbantes dans leurs zones de charge d'espace, permettent de collecter le photocourant engendré par la lumière.

Un détecteur conforme à l'invention peut comprendre un ensemble de cavités résonantes formant une matrice de détection, chaque cavité résonante correspondant à un pixel.

De façon précise, la présente invention a pour objet un détecteur multispectral, caractérisé en ce qu'il comprend au moins une cavité résonante qui est conçue pour résonner à au moins deux longueurs d'onde, des ondes stationnaires propres à ces longueurs d'ondes s'établissant pour séparer ces longueurs d'onde, en ce que cette cavité résonante contient au moins deux couches absorbantes qui sont respectivement associées et adaptées à ces longueurs d'onde, de manière à absorber respectivement les rayonnements correspondant à ces longueurs d'onde, et qui sont placées sur des ventres respectivement propres à ces ondes stationnaires, en ce que cette cavité contient aussi au moins deux jonctions P-N, les couches absorbantes étant respectivement placées dans les zones de charge d'espace de ces jonctions, et en ce que le détecteur comprend aussi, pour chaque cavité, au moins deux contacts électriques permettant de polariser en inverse l'une ou l'autre des deux jonctions P-N pour détecter le rayonnement correspondant.

De préférence, le détecteur objet de l'invention comprend, pour chaque cavité résonante, trois contacts électriques permettant de polariser en inverse les deux jonctions P-N pour détecter simultanément les rayonnements correspondants.

Selon un mode de réalisation particulier du détecteur objet de l'invention, chaque cavité résonante est délimitée par un premier miroir et par un deuxième miroir qui laisse passer les rayonnements à détecter et en ce que le premier miroir est choisi dans le groupe comprenant les miroirs de Bragg, les miroirs multicouches diélectriques et les films métalliques.

Le deuxième miroir peut être choisi dans le groupe comprenant les miroirs de Bragg et les miroirs multicouches diélectriques.

En variante, le deuxième miroir est constitué par l'interface air-cavité résonante.

Comme on l'a vu plus haut, le détecteur objet de l'invention peut comprendre un ensemble de cavités résonantes qui a une structure matricielle.
Le détecteur objet de l'invention permet :
- l'utilisation de couches actives minces du fait du renforcement de l'absorption par effet de résonance, la réduction du volume actif permettant un fonctionnement à plus haute température que ne le permettent des dispositifs connus, mentionnés plus haut,
- la détection bicolore sélective par effet intrinsèque de la cavité résonante, sans ajout de filtres supplémentaires, et
- la séparation, pour chaque pixel, des signaux électriques correspondant aux différentes longueurs d'onde détectées.

### Brève description des dessins

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe schématique d'un mode de réalisation particulier du détecteur multispectral objet de l'invention, ayant une cavité résonante dont l'un des deux miroirs est un miroir de Bragg épitaxié,
- la figure 2 est une vue en coupe schématique d'un autre mode de réalisation particulier, dans lequel le miroir est simplement constitué par l'interface entre l'air et le matériau semiconducteur où se trouve la cavité résonante,
- la figure 3 est une vue en coupe schématique d'un autre mode de réalisation particulier, dans lequel ce miroir est un dépôt de multicouches diélectriques,
- la figure 4 est un schéma électrique d'un détecteur conforme à l'invention, du genre de ceux qui sont représentés sur les figures 1 à 3,
- la figure 5 illustre schématiquement le diagramme de bandes de ces détecteurs des figures 1 à 3,
- la figure 6 illustre schématiquement les ondes stationnaires et les couches absorbantes dans la cavité résonante des détecteurs des figures 1 à 3,
- la figure 7 représente les variations de la réponse de ces détecteurs des figures 1 à 3 en fonction de la longueur d'onde, et
- la figure 8 est une vue en perspective schématique et partielle d'un détecteur multispectral conforme à l'invention, comprenant un ensemble de cavités résonantes du genre de celles des figures 1 à 3.

### Exposé détaillé de modes de réalisation particuliers

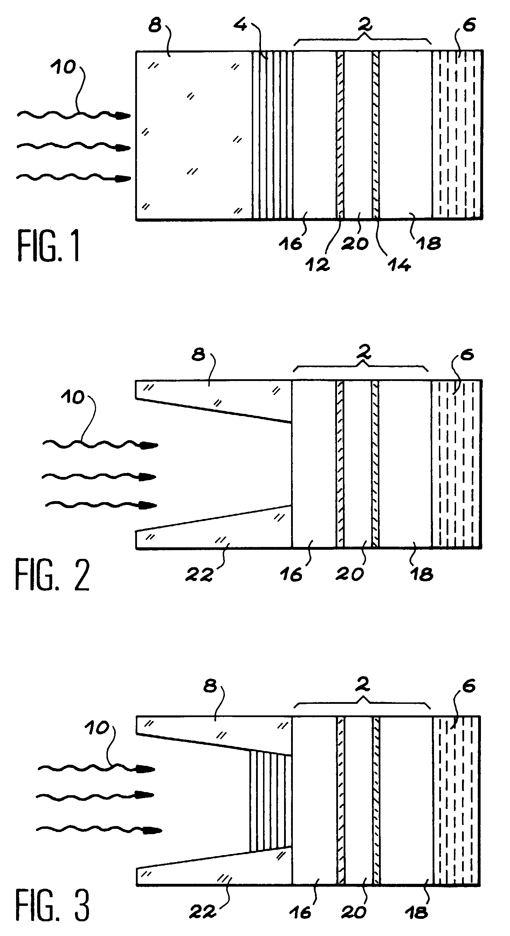

Le détecteur multispectral conforme à l'invention, qui est schématiquement représenté en coupe sur la figure 1, est destiné à détecter des rayonnements de longueurs d'ondes respectives λ₁ et λ₂.

Ce détecteur comprend une cavité résonante 2 qui est une cavité de Fabry-Pérot et qui est délimitée par deux miroirs 4 et 6.

La cavité 2 et les deux miroirs 4 et 6 qui délimitent cette cavité sont formés sur un substrat semiconducteur monocristallin 8 qui est transparent aux rayonnements que l'on détecte, ces rayonnements ayant la référence 10 sur la figure 1.

Ces rayonnements pénétrent par la face inférieure du substrat avant d'atteindre la cavité résonante du détecteur.

Le miroir 4 constitue le miroir inférieur du détecteur tandis que le miroir 6 constitue le miroir supérieur de ce détecteur.

La cavité 2 est conçue pour résonner aux deux longueurs d'onde λ₁ et λ₂.

Des ondes stationnaires propres à ces longueurs d'onde λ₁ et λ₂ s'établissent dans la cavité 2 pour séparer ces longueurs d'onde.

La cavité résonante 2 contient deux couches absorbantes 12 et 14 qui sont respectivement associées et adaptées à ces longueurs d'onde λ₁ et λ₂ de manière à absorber respectivement le rayonnement de longueur d'onde λ₁ (couche 12) et le rayonnement de longueur d'onde λ₂ (couche 14).

La cavité résonante 2 contient aussi deux jonctions P-N.

On voit sur la figure 1 une couche semiconductrice 16 de type P et une autre couche semiconductrice 18 également de type P ainsi qu'une couche semiconductrice 20 de type N comprise entre les couches 16 et 18.

On obtient ainsi les deux jonctions P-N.

La couche absorbante 12 est placée dans la zone de charge d'espace de la jonction formée par les couches 16 et 20.

La couche absorbante 14 est placée dans la zone de charge d'espace de la jonction formée par les couches 18 et 20.

Les couches absorbantes 12 et 14, que l'on peut également appeler couches actives, et les couches 16, 18 et 20 sont des couches semiconductrices minces, doivent avoir l'épaisseur requise pour que l'épaisseur totale des couches 16, 12, 20, 14 et 18 produise la résonance de la cavité aux longueurs d'onde λ₁ et λ₂.

La cavité résonante 2 est formée par épitaxie sur le substrat semiconducteur monocristallin 8.
Le miroir supérieur 6 peut être :
- un miroir de Bragg formé par épitaxie sur la couche 18 ou
- une structure multicouche diélectrique déposée sur cette couche 18 ou encore
- un film métallique déposé sur cette couche 18.

Dans l'exemple de la figure 1, le miroir inférieur 4 est un miroir de Bragg formé par épitaxie sur le substrat 8 avant la formation de la cavité résonante.

Dans l'exemple de la figure 2, un perçage 22 est formé au niveau de la cavité 2, dans le substrat 8, par gravure de ce substrat 8, faisant ainsi apparaître une interface entre l'air et le matériau semiconducteur qui constitue la couche 16.

Le miroir inférieur 4 est alors constitué par cette interface.

Dans l'exemple de la figure 3, on grave encore le substrat semiconducteur 8 pour former le perçage 22 au niveau de la cavité 2 et l'on forme un dépôt de multicouches diélectriques au fond de la cavité ainsi obtenue.

Ce dépôt de multicouches diélectriques, qui est en contact avec la couche semiconductrice 16, constitue alors le miroir inférieur 4 de la cavité résonante.

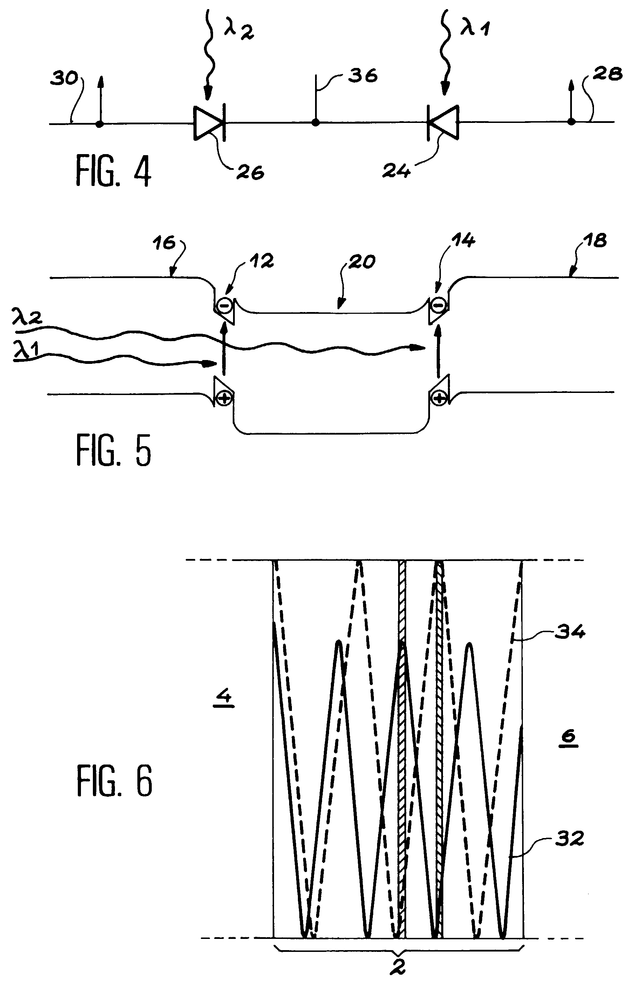

La figure 4 montre le schéma électrique du détecteur conforme à l'invention dont les variantes sont représentées sur les figures 1 à 3.

On voit que ce détecteur contient deux diodes photodétectrices 24 et 26.

La diode 24 est associée à la jonction P-N formée par les couches 16 et 20 et la diode 26 est associée à la jonction P-N formée par les couches 18 et 20.

On voit sur la figure 4 que ce détecteur comprend aussi deux contacts électriques 28 et 30.

Les cathodes des diodes sont reliées l'une à l'autre et le contact électrique 28 (ou contact supérieur) est relié à l'anode de la diode 24, qui est destinée à la détection du rayonnement de longueur d'onde λ₁, tandis que le contact 30 (ou contact inférieur) est relié à l'anode de la diode 26, qui est destinée à détecter le rayonnement de longueur d'onde λ₂.

Ces contacts électriques ne sont pas représentés sur les figures 1 à 3 mais l'on précise que les contacts électriques 28 et 30 correspondant à la cavité résonante que l'on voit sur les figures 1 à 3 sont pris respectivement dans la partie supérieure de cette cavité (du côté de la couche 10 ayant un dopage de type P) et dans la partie inférieure de cette cavité (du côté de la couche 16 ayant aussi un dopage de type P).

La figure 5 montre le diagramme de bandes correspondant aux couches 12, 14, 16, 18 et 20.

On précise que la couche active 12, dont la composition est adaptée à la longueur d'onde λ₁ qu'elle doit détecter, est placée dans la cavité résonante 2, sur un ventre de l'onde stationnaire propre à cette longueur d'onde λ₁.

De même, la couche active 14, dont la composition est adaptée à la longueur d'onde λ₂ qu'elle doit détecter, est placée dans la cavité résonante 2, sur un ventre de l'onde stationnaire propre à cette longueur d'onde λ₂.

La figure 6 montre la position des couches actives 12 et 14 de la cavité 2 (qui résonne aux longueurs d'ondes λ₁ et λ₂).

Dans l'exemple de la figure 6, λ₁ est égal à 3,04 µm et λ₂ est égal à 3,91 µm.

On voit également sur la figure 6 l'onde stationnaire 32 correspondant à la longueur d'onde λ₁ et l'onde stationnaire 34 correspondant à la longueur d'onde λ₂.

On explique ci-après le fonctionnement des détecteurs des figures 1 à 3.

Seuls pénètrent dans la cavité résonante 2 les rayonnements incidents ayant les longueurs d'ondes de résonance λ₁ et λ₂.

Chaque couche active 12 ou 14, de par sa position dans la cavité, ne "voit" qu'une longueur d'onde.

La lumière est absorbée de manière très efficace (du fait de la résonance) dans les couches actives et crée des paires de charges électroniques.

La lumière de longueur d'onde λ₂ (respectivement λ₁) est absorbée dans la jonction P-N supérieure, correspondant aux couches 18 et 20 (respectivement dans la jonction P-N inférieure, correspondant aux couches 16 et 20).

Lorsque le contact électrique supérieur 28 est porté à un potentiel électrique positif adéquat par rapport au contact électrique inférieur 30, la jonction P-N supérieure se trouve polarisée en direct alors que la jonction P-N inférieure est, quant à elle, polarisée en inverse.

Dans ce cas, le courant i₁ (figure 4) sortant du détecteur (au niveau du contact électrique 30) est commandé par l'absorption dans la jonction inférieure.

Ce courant i₁ est donc proportionnel à l'intensité de la lumière de longueur d'onde λ₁.

Inversement, lorsque le contact électrique inférieur 30 est porté à un potentiel positif adéquat par rapport au contact électrique supérieur 28, la jonction P-N inférieure se trouve polarisée en direct alors que la jonction P-N supérieure est, quant à elle, polarisée en inverse.

Dans ce cas, le courant i₂ (figure 4) sortant du détecteur (au niveau du contact électrique 28) est proportionnel à l'intensité de la lumière de longueur d'onde λ₂.

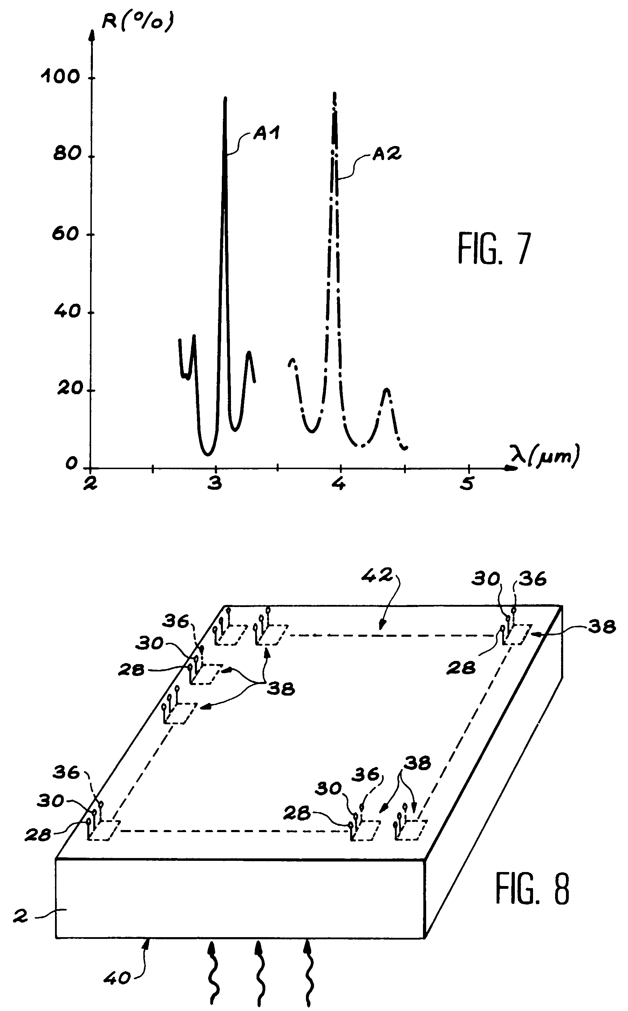

La figure 7 donne la réponse spectrale R (exprimée en pourcentage) en fonction de la longueur d'onde λ (exprimée en micromètres).

Cette réponse spectrale est calculée pour le système bicolore correspondant aux longueurs d'ondes λ₁=3,04 µm et λ₂=3,91 µm, suivant la polarisation.

On voit sur la figure 7 une première courbe A1 correspondant à une première polarisation permettant la détection de la lumière de longueur d'onde λ₁.
On voit aussi une courbe A2 correspondant à une deuxième polarisation permettant la détection de la lumière de longueur d'onde λ₂.

Le fonctionnement du détecteur permet donc de séparer les deux longueurs d'ondes détectées, et ce de manière séquentielle.

Cependant, on peut prévoir un contact électrique supplémentaire 36 (figure 4) au niveau de la couche semiconductrice 20 ayant un dopage de type N pour polariser en même temps les deux jonctions P-N en inverse et donc détecter simultanément les deux longueurs d'ondes λ₁ et λ₂.

Dans ce cas, les contacts électriques 28 et 30 sont simultanément portés à des potentiels négatifs adéquats par rapport au contact électrique 36.

La figure 8 illustre schématiquement un autre détecteur multispectral conforme à l'invention, comprenant un ensemble de détecteurs élémentaires 38.

Chacun de ces détecteurs élémentaires comprend une cavité résonante du genre de celle de la figure 1 ou 2 ou 3 (délimitée par deux miroirs et formée sur un substrat semiconducteur monocristallin 2).

L'ensemble de ces cavités et donc des détecteurs élémentaires a une structure matricielle, comme on le voit sur la figure 8.

Les rayonnements à détecter arrivent encore par la face inférieure 40 du substrat 2 (commun à tous les détecteurs élémentaires).

Les contacts électriques 28 et 30 et l'éventuel contact électrique 36 associé à chaque détecteur élémentaire 38 débouchent au niveau de la face supérieure 42 du détecteur (face opposée à celle par laquelle arrivent les rayonnements à détecter).

On est ainsi capable de détecter des images aux longueurs d'ondes λ₁ et λ₂.

Chaque cavité résonante et donc chaque détecteur élémentaire 38 correspondent à un pixel.

Pour obtenir l'image à la longueur d'onde λ₁, on polarise successivement les couples de contacts 28, 30 de la manière appropriée, expliquée plus haut, pour obtenir successivement les courants il correspondant à ces pixels et permettant de former cette image à la longueur d'onde λ₁.

Ensuite, on polarise successivement ces couples de contact 28, 30 de la manière appropriée, expliquée plus haut, pour obtenir successivement les courants i₂ correspondant aux pixels et permettant de former l'image à la longueur d'onde λ₂.

Lorsque les contacts électriques 36 sont présents, on peut polariser, de la façon expliquée plus haut, les triplets de contacts 28, 30, 36 pour obtenir simultanément l'image à la longueur d'onde λ₁ et l'image à la longueur d'onde λ₂.

Bien entendu, au lieu d'utiliser des cavités résonantes contenant chacune un empilement de type P-N-P, on pourrait utiliser des cavités résonantes contenant chacune un empilement de type N-P-N (la couche 16 étant alors de type N, la couche 20 de type P et la couche 18 de type N).

Des polarisations électriques appropriées, déterminables par l'homme du métier, permettraient encore d'obtenir des images à la longueur d'onde λ₁ et des images à la longueur d'onde λ₂.

Dans un mode de réalisation particulier non représenté, chaque cavité résonante contient non pas deux couches actives mais plus de deux couches actives qui sont respectivement placées dans les zones de charge d'espace de jonctions P-N, de manière à pouvoir détecter plus de deux longueurs d'onde.

On peut alors réaliser des cavités résonantes contenant chacune une succession de couches semiconductrices de type P qui alternent avec des couches semiconductrices de type N et placer les couches actives correspondant respectivement aux diverses longueurs d'ondes dans les zones de charge d'espace des jonctions P-N ainsi obtenues.

Les documents qui sont mentionnés dans la présente description sont les suivants :
(1) US-A-4,956,686 (Borrello et al.)
(2) US-A-5,113,076 (Schulte)
(3) "Integrated two-color detection for advanced FPA applications", J.A. Wilson et al., SPIE San Diego, 24 au 29 juillet 1994, p. 1 à 9
(4) "High quantum efficiency dual wavelength resonant-cavity photodetector", A. Srinivasan et al., Appl. Phys. Lett., 66(5), 30 janvier 1995, p. 535 à 537.
(5) EP 0622856A (AT&T Corp)
(6) IEEE Journal of Quantum Electronics vol.27, n°8, 1 août 1991, pages 2025 à 2034.

## Revendications

1. Détecteur multispectral, caractérisé en ce qu'il comprend au moins une cavité résonante (2) qui est conçue pour résonner à au moins deux longueurs d'onde, des ondes stationnaires propres à ces longueurs d'onde s'établissant pour séparer ces longueurs d'onde, en ce que cette cavité résonante contient au moins deux couches absorbantes (12, 14) qui sont respectivement associées et adaptées à ces longueurs d'onde, de manière à absorber respectivement les rayonnements correspondant à ces longueurs d'onde, et qui sont placées sur des ventres respectivement propres à ces ondes stationnaires, en ce que cette cavité résonante contient aussi au moins deux jonctions P-N, les couches absorbantes étant respectivement placées dans les zones de charge d'espace de ces jonctions, et en ce que le détecteur comprend aussi, pour chaque cavité, au moins deux contacts électriques (28, 30, 36) permettant de polariser en inverse l'une ou l'autre des deux jonctions P-N pour détecter le rayonnement correspondant.

2. Détecteur selon la revendication 1, caractérisé en ce qu'il comprend, pour chaque cavité résonante, trois contacts électriques (28, 30, 36) permettant de polariser en inverse les deux jonctions P-N pour détecter simultanément les rayonnements correspondants.

3. Détecteur selon l'une quelconque des revendications 1 et 2, caractérisé en ce que chaque cavité résonante (2) est délimitée par un premier miroir (6) et par un deuxième miroir (4) qui laisse passer les rayonnements à détecter et en ce que le premier miroir (6) est choisi dans le groupe comprenant les miroirs de Bragg, les miroirs multicouches diélectriques et les films métalliques.

4. Détecteur selon la revendication 3, caractérisé en ce que le deuxième miroir (4) est choisi dans le groupe comprenant les miroirs de Bragg et les miroirs multicouches diélectriques.

5. Détecteur selon la revendication 3, caractérisé en ce que le deuxième miroir (4) est constitué par l'interface air-cavité résonante.

6. Détecteur selon l'une quelconque des revendications 1 à 5, caractérisé en ce qu'il comprend un ensemble de cavités résonantes qui a une structure matricielle.
